Europäisches Patentamt

European Patent Office

Office européen des brevets

(11) Numéro de publication: **0 210 283 B1**

(12)  **FASCICULE DE BREVET EUROPEEN**

(45) Date de publication de fascicule du brevet:
**12.06.91**

(51) Int. Cl.⁵: **H01L 25/04**, H01L 31/02

(21) Numéro de dépôt: **84440036.6**

(22) Date de dépôt: **08.08.84**

(54) **Balise alimentée par cellules solaires.**

(30) Priorité: **24.10.83 FR 8317026**

(43) Date de publication de la demande:
**04.02.87 Bulletin 87/06**

(45) Mention de la délivrance du brevet:
**12.06.91 Bulletin 91/24**

(84) Etats contractants désignés:
**AT BE CH DE GB IT LI LU NL SE**

(56) Documents cités:
**FR-A- 2 394 895**
**FR-A- 2 450 748**
**FR-A- 2 469 806**
**GB-A- 2 115 915**
**US-A- 3 424 907**

**PATENTS ABSTRACTS OF JAPAN, vol. 7, no.**
**13 (E-153)[1158], 19 janvier 1983; & JP - A - 57**
**172 777**

(73) Titulaire: **Pagnol, Frédéric**
**Domaine de l'Etoile**
**F-06610 La Gaude(FR)**

(72) Inventeur: **Ratti, Claude**
**4 Avenue Jacques Abba**
**F-06320 Cap d'Ail(FR)**
Inventeur: **Pagnol, Frédéric**
**Domaine de l'Etoile**
**F-06610 La Gaude(FR)**

(74) Mandataire: **Nony, Michel et al**
**Cabinet NONY & CIE, 29, rue Cambacérès**
**F-75008 Paris(FR)**

## Description

La présente invention concerne les installations de balisage dont l'alimentation en courant électrique est assurée par des cellules solaires photovoltaïques et en particulier, mais non exclusivement, les balises marines.

En dépit de la simplicité et de l'intérêt économique manifestes de ce type de matériel, sa diffusion se trouve encore relativement limitée en raison de son faible rendement énergétique par rapport à son encombrement.

Ainsi, on peut mentionner à titre d'exemple qu'une balise marine de type usuel, ayant une hauteur d'environ 5m et pesant 1,5 tonne exige pour son fonctionnement une surface de 1m² de cellules, pesant 100 kg, pour obtenir un rendement de 80 watts. Au surplus ce matériel est actuellement relativement coûteux.

Cette insuffisance se trouve liée à la constitution desdites cellules, qui sont réunies en panneaux plats extérieurs dont on s'efforce de régler l'inclinaison et l'orientation selon la latitude, mais sans que jusqu'ici on soit parvenu à une efficacité réellement satisfaisante, du fait du caractère imprécis et aléatoire de ce réglage.

Au surplus ces panneaux extérieurs sont constamment exposés aux embruns d'eau de mer, ce qui impose l'installation de traversées étanches et de sérieuses contraintes de maintenance.

Le document GB-A-2 115915 décrit une balise solaire de ce type dans laquelle les cellules photovoltaïques sont disposées sur des panneaux séparés des autres éléments constitutifs de la balise (accumulateurs, dispositif de signalisation).

La présente invention permet d'éviter l'ensemble de ces limitations et de ces inconvénients. Elle consiste, pour l'essentiel, à regrouper les cellules solaires sous une forme compacte, offrant une surface efficace maximum en ne privilégiant aucune orientation, c'est-à-dire en bénéficiant en permanence d'un rendement également maximum eu égard à l'ensemble des conditions d'utilisation.

La balise selon l'invention comporte un caisson étanche présentant à sa partie supérieure une forme sensiblement tronconique, les cellules photovoltaïques étant incorporées dans la paroi de la partie sensiblement tronconique dudit caisson qui renferme à son intérieur les batteries destinées à accumuler l'énergie produite par les cellules ainsi que les dispositifs électroniques nécessaires au fonctionnement de la balise.

La configuration des cellules solaires équipant une balise affecte dans son ensemble la forme d'une surface de révolution à axe vertical et à génératrice inclinée sur cet axe d'un angle éventuellement fonction de la latitude du lieu d'utilisation ; cette surface peut être subdivisée en secteurs plans de petites dimensions, correspondant chacun à une cellule ou à un groupe de cellules, ces secteurs étant accordés par des lignes droites ou courbes, ce qui n'affecte pas ladite configuration d'ensemble et le rendement qui en résulte, qui demeure constamment maximum dès lors que l'angle d'inclinaison précité a été réglé.

Une telle configuration peut être adoptée avec des cellules de tout type. Selon une réalisation préférentielle de l'invention, les cellules sont encapsulées dans une masse de polyméthacrylate de méthyle, ce qui présente l'avantage supplémentaire d'un poids moins élevé et d'une moins grande fragilité ; au surplus, dans ce cas, l'ensemble des cellules et des éléments annexes, à savoir notamment les batteries et les circuits électroniques, sont également encapsulés dans un caisson unique, ce qui assure une isolation complètement étanche de tout l'ensemble, en éliminant les problèmes précités.

Selon une variante particulièrement avantageuse de cette dernière réalisation, on utilise pour l'encapsulation des cellules un polyméthacrylate dit "dopé", qui grâce à un phénomène de réflexion interne, assure un rendement photo-énergétique encore supérieur.

A titre d'exemple à considérer comparativement avec les indications numériques précédentes, on peut mentionner qu'une balise selon l'invention, n'ayant qu'un encombrement de 0,65 m de diamètre, et un poids de 25 kg, développe une puissance de 26 watts pour une surface photosensible de 0,2m², soit un gain relatif de puissance de l'ordre de 25 %.

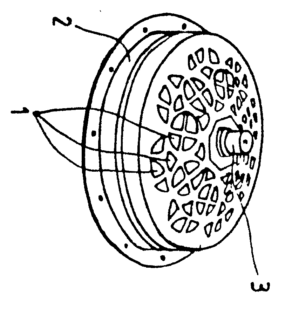

L'invention sera illustrée plus complètement grâce au dessin annexé qui représente en perspective une balise selon l'invention.

Sur ce dessin, on voit que l'ensemble des cellules photosensibles 1 sont réparties sur une surface en forme de tronc de cône constituant la face supérieure d'un caisson 2 dans lequel sont enfermés la batterie et les circuits électriques de la balise. Dans l'axe de ce caisson est adapté soit un système optique, tel que 3, soit un système électronique tel qu'une antenne, ou tout autre accessoire, tel que par exemple une mini-station météo dont les renseignements sont transmis à des postes récepteurs fixes, au sol, ou mobiles tel qu'un avion.

Cette balise peut être montée de manière usuelle aux différents types de bouées maritimes, fluviales ou terrestres ; une autre application encore en est le balisage des pistes d'aéroports, par voie optique ou électronique.

D'autres réalisations encore pourront être la réalisation de détecteurs d'incendies de forêts et le balisage de stations de pompage notamment dans les pays en voie de développement.

## Revendications

1. Balise dont l'alimentation en courant électrique est assurée par des cellules photovoltaïques (1) fonctionnant avec l'énergie solaire, caractérisée par le fait qu'elle comporte un caisson étanche (2) présentant à sa partie supérieure une forme sensiblement tronconique, les cellules photovoltaïques (1) étant incorporées dans la paroi de la partie sensiblement tronconique dudit caisson qui renferme à son intérieur les batteries destinées à accumuler l'énergie produite par les cellules ainsi que les dispositifs électroniques nécessaires au fonctionnement de la balise.

2. Balise selon la revendication 1, caractérisée par le fait qu'elle comporte au centre de sa partie supérieure de forme sensiblement tronconique, un dispositif électronique (3) qui assure le balisage.

3. Balise selon l'une quelconque des revendications 1 et 2, caractérisée par le fait que la surface tronconique supérieure du caisson est subdivisée en secteurs plans de petite dimension dans chacun desquels est incorporée une cellule ou un groupe de cellules photovoltaïques (1).

4. Balise selon l'une quelconque des revendications 1 et 3, caractérisée par le fait que les cellules photovoltaïques (1) sont incorporées au caisson en étant directement encapsulées dans une masse de matière synthétique transparente telle par exemple que du polyméthacrylate de métyle dopé.

5. Balise selon l'une quelconque des revendications précédentes, caractérisée par le fait que la partie supérieure tronconique du caisson a une conicité qui est fonction de la latitude du lieu d'utilisation de la balise.

## Claims

1. Beacon which is electrically powered by photovoltaic cells (1) operated by solar energy, characterised in that it comprises a sealed housing (2) having a substantially truncated shape at its upper part, the photo-voltaic cells (1) being integrated in the wall of the substantially truncated part of said housing which encloses inside it the batteries intended for storing the energy produced by the cells as well as the electronic devices necessary for the functioning of the beacon.

2. Beacon according to Claim 1, characterised in that it comprises at the centre of its substantially truncated upper part an electronic device (3) which ensures the beaconing operation.

3. Beacon according to any one of Claims 1 and 2, characterised in that the upper truncated surface of the housing is subdivided into plane sectors of small dimensions, in each of which there is integrated a photo-voltaic cell (1) or a group of photo-voltaic cells (1).

4. Beacon according to any one of Claims 1 and 3, characterised in that the photo-voltaic cells (1) are integrated in the housing, being directly encapsulated in a mass of synthetic transparent material such as for example polymethacrylate of doped methyl.

5. Beacon according to any one of the preceding claims, characterised in that the upper truncated part of the housing has a conicity which is a function of the latitude of the place of use of the beacon.

## Ansprüche

1. Boje, deren Versorgung mit elektrischem Strom durch photoelektrische Zellen, die mit Sonnenenergie arbeiten, gesichert ist, dadurch gekennzeichnet, daß sie ein abgedichtetes Gehäuse (2) enthält, das im obenliegenden Teil eine im wesentlichen kegelstumpfartige Form aufweist, wobei die photoelektrischen Zellen (1) in die Wand des kegelstumpfartigen Teils des Gehäuses eingebaut sind, das im Inneren die Batterien, die die von den Zellen gelieferte Energie speichern, sowie die elektronischen Geräte, die für das Funktionieren der Boje notwendig sind, einschließt.

2. Boje nach Anspruch 1, dadurch gekennzeichnet, daß sie in der Mitte des obenliegenden im wesentlichen kegelstumpfartigen Teils ein elektronisches Gerät (3) enthält, das die Befeuerung sichert.

3. Boje nach einem der Ansprüche 1 und 2, dadurch gekennzeichnet, daß die obere kegelstumpfartige Oberfläche des Gehäuses in ebene Sektoren von kleinen Abmessungen aufgeteilt ist, in denen je eine Zelle oder eine Gruppe von photoelektrischen Zellen (1) eingebaut ist.

4. Boje nach einem der Ansprüche 1 und 3, dadurch gekennzeichnet, daß die photoelektrischen Zellen (1) in das Gehäuse eingebaut sind, indem sie direkt von einer Masse aus synthetischem, transparenten Material, wie beispielsweise dotiertem Polymethylmethacrylat, eingekapselt sind.

5. Boje nach einem der vorhergehenden Ansprüche, dadurch gekennzeichnet, daß der obenliegende kegelstumpfartige Teil des Gehäuses eine Konizität hat, die von der geographischen Beite des Einsatzortes der Boje abhängt.